# DEMANDE DE BREVET EUROPEEN

(11) **EP 1 049 170 A1**
(43) Date de publication de la demande: **02.11.2000**
(21) Numéro de dépôt: 00401165.6
(22) Date de dépôt: 27.04.2000
(51) Int. Cl.: H01L 27/146, G01T 1/24

(54) **Gamma caméra miniature a détecteurs semi-conducteurs**

(30) Priorité: 30.04.1999 FR 9905526
(71) Demandeur: COMMISSARIAT A L'ENERGIE ATOMIQUE, 75752 Paris Cédex 15 (FR)
(72) Inventeur: Monnet, Olivier, 38210 Tullins (FR); Chapuis, Alain, 38950 Saint-Martin-le-Vinoux (FR); Mestais, Corinne, 38660 La Terrasse (FR); Rostaing, Jean-Pierre, 38260 La Cote Saint-Andre (FR)
(74) Mandataire: Signore, Robert

(57) **Abrégé**

L'invention concerne une gamma caméra miniature comportant plusieurs dispositifs de détection (1a, 1b,..., 1k) de rayonnements gamma juxtaposés les uns aux autres et disposés au-dessus de moyens (2) de traitement de l'information issue de ces dispositifs de détection, chacun de ces dispositif de détection comprenant :
- une pluralité de détecteurs (4a, 4b,..., 4n) juxtaposés les uns aux autres pour former un plan de détection (4) ;
- un premier substrat (6) incluant des moyens de polarisation (10b) du plan de détection et des premiers moyens (10c) de traitement du signal détecté par ledit plan de détection ;
- un second substrat (5) placé entre le plan de détection et le premier substrat ;
- un plan de masse (8) placé entre le premier et le second substrat ; et
- un troisième substrat (7) incluant des seconds et des troisièmes moyens de traitement du signal (7a, 7b).

## Description

### Domaine de l'invention

L'invention concerne une gamma caméra miniature à détecteurs semi-conducteurs fournissant localement et instantanément l'image détectée.

Cette gamma caméra trouve des applications dans tous les domaines techniques où les dimensions de la caméra sont d'une grande importance. Elle trouve, en particulier, des applications dans le domaine de la médecine et, plus précisément, de la chirurgie.

### Etat de la technique

Dans le domaine médical, et en particulier en chirurgie, il est utile de pouvoir visualiser la ou les zone(s) à traiter, avant de les traiter ou pendant le traitement. Par exemple, un chirurgien qui doit extraire les parties cancéreuses des tissus d'un patient, pourrait procéder à la visualisation de ces parties de tissus avant de les retirer.

Il existe actuellement des sondes préopératoires dont le détecteur est réalisé à base de cristaux couplés sur un photomultiplicateur à localisation. Cependant, un tel détecteur est trop volumineux et trop lourd pour être utilisé en chirurgie.

Des solutions de détecteurs émergent, à base de petit cristal couplé sur un demi-conducteur. Mais ces détecteurs présentent des difficultés de sensibilité à la haute énergie des photons utilisés en médecine nucléaire. Ces détecteurs visent plutôt le domaine d'énergie inférieur à 100 KeV, en mesure d'intégrale de flux de photons et d'énergie déposée.

Par ailleurs, il existe, dans d'autres domaines techniques, des gamma caméras réalisées au moyen de dispositifs de détection, comprenant eux-mêmes un ensemble de détecteurs juxtaposés les uns aux autres et formant un plan de détection supporté par un substrat et séparé de ce substrat par une plaque de connexion. Une telle gamma caméra est décrite, par exemple, dans la demande de brevet WO-96/20412. Cependant, ces gamma caméras sont généralement de dimensions assez grandes, c'est-à-dire de l'ordre de 30 à 40 cm par 40 à 50 cm.

Un autre type de dispositif de détection destiné à être utilisé sur une gamma caméra est également connu. Ce dispositif de détection est constitué d'une pluralité de détecteurs placés côte à côte sur un substrat en céramique pour former un plan de détection. Le substrat en céramique a pour but d'assurer la tenue mécanique de l'ensemble du dispositif.

Pour fonctionner, un tel dispositif de détection doit être polarisé. Pour cela, le dispositif est muni de moyens de polarisation, tels qu'une résistance et un condensateur de liaison : la résistance est reliée à la masse quand le détecteur est relié à la haute tension et inversement. Ces moyens de polarisation sont placés sur la surface du substrat en céramique.

Ce dispositif de détection comporte également des moyens de traitement des signaux provenant des détecteurs ; ces moyens de traitement se présentent sous la forme d'un ASIC (Application Specific Integrated Circuit) placé dans le substrat.

Dans ce dispositif de détection connu, le substrat en céramique est mince de façon à être transparent aux rayons y qui doivent être détectés dans le plan de détection situé sous le substrat. Le substrat est mince aussi de façon à ce que l'ASIC de mesure puisse être placé le plus proche possible du plan de détection, ce qui permet de minimiser les capacités parasites de la liaison entre le plan de détection et l'entrée de l'ASIC.

Par ailleurs, il est connu que les moyens de polarisation d'un tel dispositif doivent être placés sur le chemin le plus court entre le plan de détection et l'ASIC. Aussi, puisque le substrat est mince, la résistance et le condensateur de polarisation sont implantés, par sérigraphie, sur la surface du substrat.

Un tel dispositif de détection est décrit, en particulier, dans la publication, intitulée « A Basic Component for ISGRI, the CdTe gamma camera on board the INTEGRAL Satellite » de M. ARQUES et al. Le dispositif de détection décrit dans cette publication est appliqué à un satellite. Dans ce cas particulier, le dispositif de détection comporte deux étages de détection pour deux gammes d'énergies. Sur ce dispositif de détection, un ASIC de mesure est installé de façon à être proche des détecteurs afin de minimiser les capacités parasites de la liaison entre les détecteurs et l'entrée de l'ASIC. Dans ce dispositif, les bruits liés à l'électronique de traitement de l'information ne gênent en rien la détection des signaux. Par ailleurs, ces bruits peuvent être élevés en comparaison des très faibles charges électriques mesurées. De plus, bruits et signal à mesurer sont synchrones. De ce fait, les temps de mesure et traitements électroniques sont séquencés : pendant le temps de mesure d'un photon, l'électronique de traitement du signal est inhibée. La mesure est mémorisée, puis traitée. Si un photon se présente sur le détecteur pendant le temps de traitement, celui-ci n'est pas pris en compte. Ce mode de fonctionnement est particulièrement pénalisant en médecine nucléaire.

Cependant, de nombreux domaines techniques, et en particulier le domaine de la chirurgie, nécessitent l'utilisation d'une gamma caméra pour détecter avec une bonne efficacité de détection des signaux dont l'amplitude est proche de celle des bruits électroniques. Dans ce cas, il est nécessaire de protéger les détecteurs des perturbations électroniques dues à l'électronique de traitement des signaux détectés. C'est le cas, en particulier, du domaine de la médecine nucléaire utilisant des détecteurs à base de semi-conducteur, où les signaux à détecter sont de l'ordre de grandeur du femto Coulomb.

Dans ce cas, il est classique, pour l'homme du métier, d'utiliser un plan de masse pour protéger les détecteurs des perturbations dues aux bruits électroniques. Cependant, ajouter un plan de masse entre le substrat en céramique et les détecteurs pose un premier problème quant à la compacité du dispositif ; en effet, les composants de polarisation sont déportés, ce qui rend le dispositif plus encombrant ou crée une zone morte dans la zone utile. Cet ajout pose un second problème quant à la capacité parasite apportée par ce plan de masse qui doit produire le moins d'effet possible sur le signal.

De plus, l'homme du métier sait que l'ensemble résistance/condensateur doit être placé sur le chemin le plus court entre le détecteur et l'ASIC. Mais, il ne peut être situé sur le plan de masse car ce dernier doit être uniforme. De plus, cet ensemble résistance/condensateur ne peut être situé dans l'ASIC, faute de place.

Par ailleurs, ajouter un plan de masse entre l'ASIC et le détecteur, sur un dispositif de détection classique, comme celui décrit précédemment, augmenterait le bruit du signal, car le substrat en céramique sur lequel est fixé l'ASIC est fin.

### Exposé de l'invention

L'invention a justement pour but de remédier aux inconvénients énoncés précédemment. A cette fin, elle propose une gamma caméra miniature (appelée aussi « micro gamma caméra ») permettant la détection de signaux ayant pour ordre de grandeur le femto Coulomb et fournissant localement et instantanément l'image détectée.

De façon plus précise, l'invention concerne une gamma caméra miniature comportant plusieurs dispositifs de détection de rayonnements gamma juxtaposés les uns aux autres, sans zone morte, et disposés au-dessus de moyens de traitement de l'information issue de ces dispositifs de détection, chacun de ces dispositif de détection comprenant :
- une pluralité de détecteurs juxtaposés les uns aux autres pour former un plan de détection ;
- un premier substrat incluant des moyens de polarisation du plan de détection et des premiers moyens de traitement du signal détecté par ledit plan de détection ;
- un second substrat placé entre la plan de détection et le premier substrat ;
- un plan de masse placé entre le premier et le second substrats ; et
- un troisième substrat incluant des seconds et des troisièmes moyens de traitement du signal.

De préférence, le premier, le second et le troisième substrats sont réalisés chacun dans une céramique épaisse.

Selon l'invention, les seconds moyens de traitement du signal peuvent être de type analogique et les troisièmes moyens de traitement du signal de type numérique, ces derniers assurant l'acceptation ou le rejet de chaque rayonnement gamma incident, en fonction de son énergie et l'adressage de chaque détecteur, c'est-à-dire du pixel à détecter, de façon à réaliser l'image globale.

Avantageusement, les dispositifs de détection comprenant des plans d'amenée de haute tension sont assemblés les uns aux autres sur le troisième substrat de connexion, par exemple par des broches, selon un assemblage jointif, sans zone morte et polarisés les uns par les autres en connectant les plans haute tension entre eux.

L'invention concerne aussi une gamma caméra grand champ, réalisée par l'assemblage de plusieurs gamma caméras miniatures.

### Brève description des dessins

- La figure 1 représente, schématiquement, une gamma caméra conforme à l'invention ;
- les figures 2A et 2B représentent, schématiquement, le premier substrat du dispositif de la figure 1, selon une vue de dessus et une vue de dessous ; et
- les figures 3A et 3B représentent schématiquement le troisième substrat du dispositif de la figure 1, selon une vue de dessus et une vue de dessous.

### Exposé de modes de réalisation de l'invention

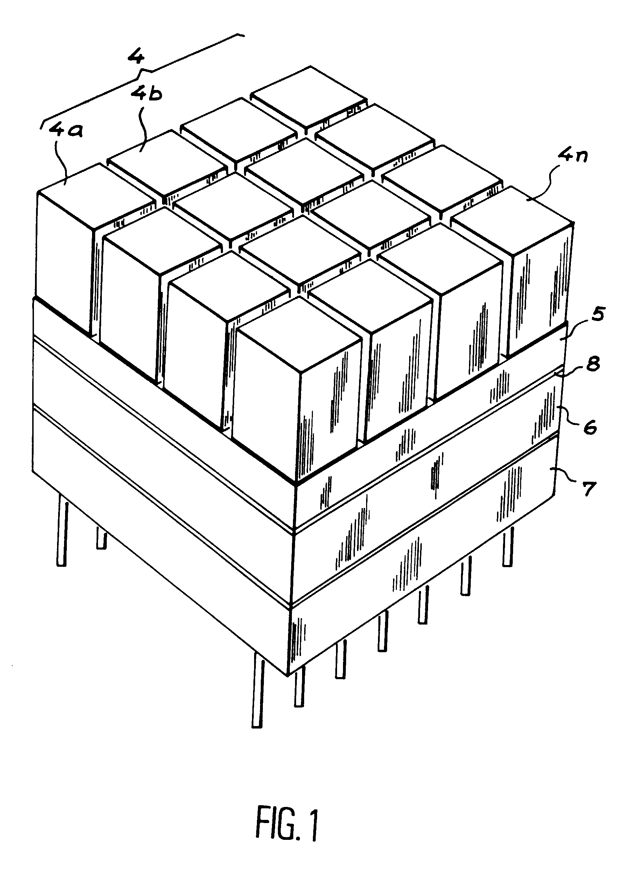

Sur la figure 1, on a représenté schématiquement une gamma caméra selon l'invention.

Cette gamma caméra comporte plusieurs dispositifs de détection juxtaposés les uns aux autres pour former le plan de prise d'images de la caméra. Ces dispositifs de détection sont placés au-dessus de moyens de traitement de l'information ; ces moyens de traitement de l'information comportent, notamment, des cartes numériques et des cartes analogiques classiques qui assurent le traitement des images fournies par les dispositifs de détection. Ces moyens de traitement de l'information assurent, notamment, la mise en forme de l'image, comme une correction de sensibilité de défauts ou encore une interpolation ; ils assurent aussi la visualisation de l'image. Comme ces moyens sont classiques, ils ne seront pas décrits de façon plus précise dans la présente demande de brevet.

Avantageusement, les dispositifs de détection sont fixés les uns avec les autres de façon à minimiser les zones mortes de détection entre les différents dispositifs de détection.

Selon l'invention, chaque dispositif de détection comporte une pluralité de détecteurs 4a, 4b,..., 4n juxtaposés les uns aux autres pour former un plan de détection 4. Ces détecteurs 4a, 4b,..., 4n constituent les pixels du dispositif de détection.

Ces détecteurs sont réalisés, par exemple, en CdZnTe ; ils sont assemblés par collage ou par soudure sur un second substrat en céramique, référencé 5.

Ces pixels détecteurs convertissent directement l'énergie des photons gamma en porteurs de charge. La collecte des porteurs de charge est réalisée grâce à des contacts déposés sur chaque détecteur (mais non représentés sur la figure par mesure de simplification), auxquels on applique une haute tension de polarisation.

Selon l'invention, le second substrat 5 est réalisé dans une céramique multicouche cofrittée, connue pour ses bonnes tolérances mécaniques, et dont l'épaisseur peut être élevée.

L'épaisseur de ce second substrat 5 est choisie de façon à obtenir un compromis entre :
a) la qualité de la résistance et la tolérance mécanique du substrat ;
b) la capacité parasite qu'il génère ;
c) le coût ;
d) la possibilité de réalisation du dispositif.

Le second substrat 5 a pour rôle, notamment, de blinder les détecteurs contre les bruits car ils se trouvent suffisamment éloignés du plan de masse.

Un tel substrat 5 a une bonne tenue mécanique ; il est donc facile d'assembler les détecteurs de la façon la plus jointive possible, afin de ne pas laisser de zone morte et, ainsi, d'obtenir une image de bonne qualité. En effet, une grande précision dans le positionnement de chacun des détecteurs, dans le plan de détection, permet de ne pas créer d'artefacts sur l'image acquise en sortie de la gamma caméra.

Le dispositif de détection comporte de plus un premier substrat 6 séparé du substrat 5 par un plan de masse 8 et un troisième substrat 7 placé sous le premier substrat 6.

Le premier substrat 6 comporte des moyens de polarisation 10b des détecteurs, tel qu'une résistance et un condensateur, identiques à ceux de l'art antérieur décrit précédemment. Ce premier substrat comporte de plus des moyens 10c de traitement des signaux produits par les détecteurs, appelés « ASIC ».

Selon l'invention, ce premier substrat en céramique est épais afin de pouvoir « noyer » les composants rapportés de façon à ne pas être obligé de les mettre à côté des détecteurs, ce qui créerait des zones mortes. Ils sont noyés dans la céramique car il n'est techniquement pas possible de sérigraphier des composants sur une céramique épaisse.

Ce premier substrat a, de plus, de bonnes propriétés de tenue mécanique, à savoir une bonne tenue en température et une bonne tenue à l'humidité, par exemple.

Cependant, comme ce premier substrat 1 est épais et réalisé en céramique frittée (qui rend impossible l'utilisation de procédé de sérigraphie), il n'est pas possible de réaliser les moyens de polarisation (le condensateur et la résistance) sur ce substrat par les procédés de sérigraphie classiques. Aussi, conformément à l'invention, le condensateur et la résistance de polarisation sont intégrés, par une technique de montage en surface(CMS), dans des cavités 10a réalisées dans ce substrat 1. Cette technique de réalisation est classique dans le domaine des circuits imprimés ; elle est décrite, par exemple, dans un document commercial de SIEMENS®, intitulé « la technique CMS-Introduction au montage en surface ».

Des moyens 10c de traitement des signaux issus des détecteurs, appelés « ASIC », sont également implantés dans le substrat 6 par la même technique que celle décrite précédemment.

Les deux substrats en céramique sont assemblés mécaniquement et électroniquement.

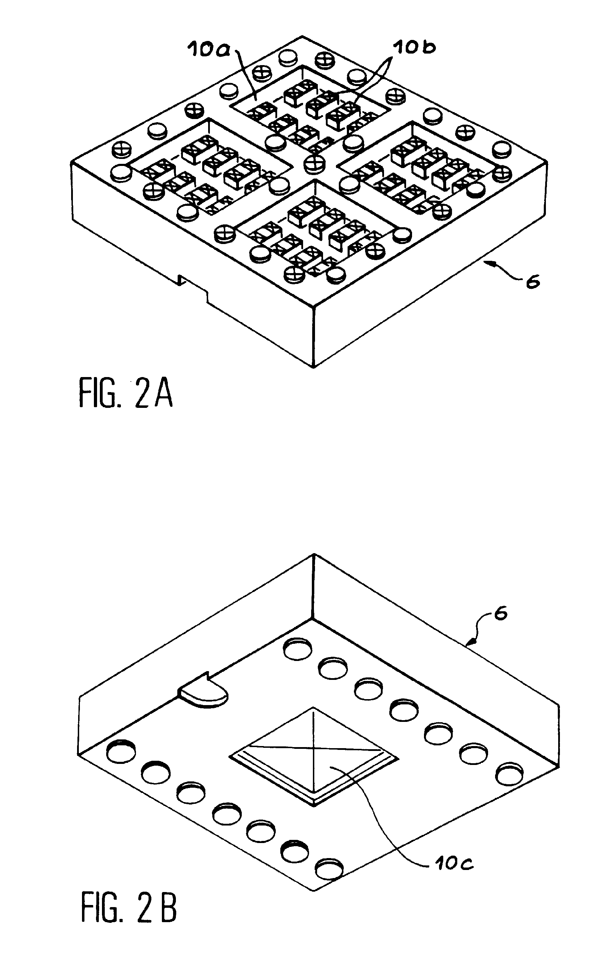

Sur les figures 2A et 2B, on a représenté, respectivement, une vue de dessus et une vue de dessous du premier substrat 6 du dispositif de détection. On voit sur la figure 2A, le substrat 6 avec des cavités 10a à l'intérieur desquelles sont implantés les composants de polarisation 10b, à savoir des condensateurs et des résistances de polarisation.

Sur la figure 2B, on a représenté ce même substrat 6 en vue de dessous dans lequel est implanté un ASIC, référencé 10c. Cet ASIC assure l'amplification et la mise en forme des signaux électroniques issus des détecteurs.

Un plan de masse 8 est placé entre ce premier substrat 6 et le deuxième substrat 5 ; ce plan de masse est constitué d'une couche métallique portée à une tension choisie, identique sur toute sa surface. Le rôle de ce plan de masse est de protéger les signaux à détecter des perturbations électromagnétiques provenant des bruits électroniques du dispositif.

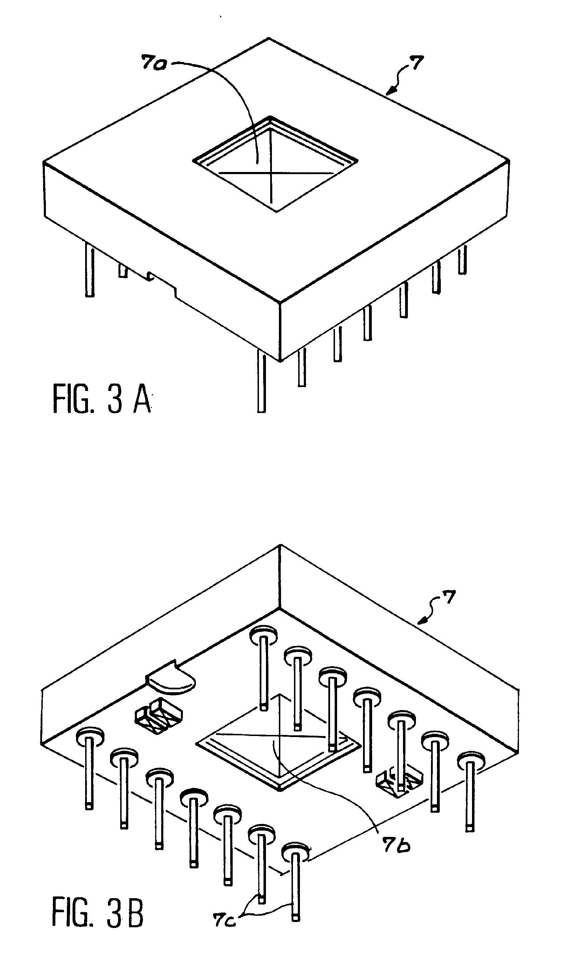

Sur les figures 3A et 3B, on a représenté schématiquement, respectivement, une vue de dessus et une vue de dessous du troisième substrat 7 du dispositif de détection. Ce troisième substrat 7 comporte deux ASICs :
- dans sa face supérieure, il comporte un ASIC 7a de type analogique qui assure le traitement du signal fourni par l'ASIC 10c du premier substrat 6 ; ce traitement peut être, par exemple, une numérisation ou une correction ;
- dans sa face inférieure, il comporte un ASIC 7b de type numérique qui décide d'accepter ou de rejeter un événement, c'est-à-dire un rayonnement γ incident, en fonction de l'énergie déposée sur le dispositif de détection. Cet ASIC numérique assure également la distribution des événements acceptés pour réaliser une image.

Ce substrat 7 comporte de plus des connexions 7c de sortie du dispositif de détection.

Ainsi, selon l'invention, l'ensemble des traitements électroniques appliqués aux signaux issus des détecteurs est réalisé au moyen de trois ASICs 10c, 7a et 7b indépendants, câblés dans l'épaisseur des substrats en céramique et associés de façon modulaire.

Chaque dispositif de détection comporte un nombre de détecteurs, par ensemble de trois substrats, qui peut varier en fonction de l'optimisation des dimensions des composants de polarisation et des ASICs. Par exemple, le plan de détection représenté sur la figure 1 comporte seize détecteurs. De même, le nombre de dispositifs de détection par micro caméra peut varier en fonction de la taille de ces dispositifs, de la dimension de l'image à obtenir et de l'application à laquelle est destinée la micro caméra.

La micro caméra ainsi réalisée a l'avantage d'être compacte et aisément maniable. Elle assure aussi une formation locale et instantanée de l'image, cette image présentant alors une bonne sensibilité, une bonne résolution énergétique et de faibles zones mortes.

Par ailleurs, plusieurs micro caméras, identiques à celle décrite précédemment, peuvent être assemblées, par exemple, sur une carte de circuit intégré, pour former une gamma caméra grand champ.

## Revendications

1. Gamma caméra miniature, caractérisée en ce qu'elle comporte plusieurs dispositifs de détection (1a, 1b,..., 1k) de rayonnements gamma juxtaposés les uns aux autres, sans zone morte, et disposés au-dessus de moyens (2) de traitement de l'information issue de ces dispositifs de détection, chacun de ces dispositif de détection comprenant :
- une pluralité de détecteurs (4a, 4b,..., 4n) juxtaposés les uns aux autres pour former un plan de détection (4) ;
- un premier substrat (6) incluant des moyens de polarisation (10b) du plan de détection et des premiers moyens (10c) de traitement du signal détecté par ledit plan de détection ;
- un second substrat (5) placé entre le plan de détection et le premier substrat ;
- un plan de masse (8) placé entre le premier et le second substrat ; et
- un troisième substrat (7) incluant des seconds et des troisièmes moyens de traitement du signal (7a, 7b).

2. Gamma caméra miniature selon la revendication 1, caractérisée en ce que le premier substrat est réalisé dans une céramique épaisse.

3. Gamma caméra miniature selon l'une quelconque des revendications 1 et 2, caractérisée en ce que le second substrat est réalisé dans une céramique épaisse.

4. Gamma caméra miniature selon l'une quelconque des revendications 1 à 3, caractérisée en ce que le troisième substrat est réalisé dans une céramique épaisse.

5. Gamma caméra miniature selon l'une quelconque des revendications 1 à 4, caractérisée en ce que les seconds moyens de traitement de signal sont de type analogique.

6. Gamma caméra miniature selon l'une quelconque des revendications 1 à 5, caractérisée en ce que les troisièmes moyens de traitement du signal sont de type numérique et qu'ils assurent, d'une part, l'acceptation ou le rejet de chaque rayonnement gamma incident, en fonction de son énergie et, d'autre part, l'adressage de chaque détecteur.

7. Gamma caméra selon l'une quelconque des revendications 1 à 6, caractérisée en ce que les dispositifs de détection sont assemblés les uns aux autres sur le troisième substrat de connexion, les dispositifs de détection étant juxtaposés sans zone morte et polarisés les uns par les autres.

8. Gamma caméra grand champ, caractérisée en ce qu'elle comporte une pluralité de gamma caméras miniatures selon l'une quelconque des revendications 1 à 7, assemblées les unes aux autres.
